# EUROPÄISCHE PATENTSCHRIFT

(11) **EP 2 436 857 B1**
(45) Veröffentlichungstag und Bekanntmachung des Hinweises auf die Patenterteilung: **05.03.2014**
(21) Anmeldenummer: 11007554.6
(22) Anmeldetag: 16.09.2011
(51) Int. Cl.: E05B 47/06

(54) **Flügelanlage mit einer Schliessvorrichtung und einer Energieüberwachung für einen Drehknauf mit einer autarken Energieversorgung**
Leaf assembly with a locking device with energy monitoring for a rotary knob with an independent energy supply
Installation de battant avec dispositif de verrouillage avec surveillance d'énergie pour poignée rotative dotée d'une alimentation en énergie autonome

(30) Priorität: 30.09.2010 DE 102010037876
(43) Veröffentlichungstag der Anmeldung: 04.04.2012
(73) Patentinhaber: Dorma GmbH + Co. KG, 58256 Ennepetal (DE)
(72) Erfinder: Wulff, Hans-Dieter, 56651 Niederdürenbach (DE); Hoff, Gunnar, Dr., 51645 Gummersbach (DE)

(56) Entgegenhaltungen:
- EP-A2- 0 994 362
- WO-A1-2009/148160
- DE-A1- 10 045 631
- DE-A1- 10 209 037
- DE-T2-602004 010 203
- US-A1- 2002 093 312

## Beschreibung

Die Erfindung betrifft eine Überwachung für Drehknäufe mit einer autarken Energieversorgung und als Teil einer Flügelanlage, insbesondere batteriegespeiste Drehknäufe.

Drehknäufe von Sicherheitszylindern werden bekanntermaßen eingesetzt, bei Aktivierung einen in einem zugeordneten Profilzylinder eines Flügelschlosses aufgenommenen Motor anzusteuern, einen Schließbart des Profilzylinders zumindest in Entriegelungsrichtung zu drehen. Nach Beenden der Aktivierung wird der Motor abgeschaltet. Die Aktivierung erfolgt typischerweise berührungslos beispielsweise mittels einer Codekarte exemplarisch in Form einer Transponderkarte, die an einen Leser des Drehknaufs angelegt oder an ihn angenähert wird und Berechtigungsdaten beinhaltet. Diese Daten werden vom Leser ausgelesen und auf Berechtigung, den jeweiligen Flügel öffnen zu dürfen, geprüft. Ist die Prüfung erfolgreich, wird der Drehknauf aktiviert, und der Flügel kann mithilfe des Motors entriegelt und damit geöffnet werden.

Diese Art von Drehknäufen wird üblicherweise mittels einer oder eines innen angeordneten Batterie bzw. Akkumulators als Energieversorgungseinrichtung autark mit Energie versorgt. Die Energieversorgungseinrichtung entlädt sich dabei sowohl während des Zeitraums der Aktivierung als auch in den Zeiten dazwischen.

Um zu verhindern, dass die Energieversorgungseinrichtung nicht mehr ausreichend Energie hat, den Drehknauf zu aktivieren oder gar die Berechtigungsdaten zu lesen, ist aus dem Stand der Technik bekannt, die Restkapazität der Energieversorgungseinrichtung zu überwachen, um einen eventuell notwendigen Wechsel der Energieversorgungseinrichtung anzeigen zu können.

In der DE 10 2006 020 309 A1 ist ein Verfahren zur Erkennung des Endes der Lebensdauer eines bestimmten Batterietyps beschrieben. Dabei werden zu Beginn des Verfahrens Grenzwertkriterien ausgewählt, die durch Messungen der Spannung an Batterieklemmen bestimmbar machen, ob die Batterie noch ausreichend Restkapazität hat oder nicht. Es werden Batteriespannung-Temperatur-Kennlinien genutzt, um die für die jeweilige Temperatur notwendige Spannung zu ermitteln. Wird die notwendige Spannung unterschritten, wird ein Zähler inkrementiert. Erreicht der Zähler einen vorbestimmten Grenzwert, kann ein Warnsignal abgegeben werden. Diese Lösung hat den Nachteil, dass die Batteriekapazität bereits nicht mehr ausreichen kann, obwohl der Zähler noch nicht den Grenzwert erreicht hat. Dies kann insbesondere passieren, wenn die Umgebungstemperatur in Bezug auf die Batterie beispielsweise über Nacht rapide fällt, sodass die Batterie keine ausreichende Kapazität mehr hat, obwohl sie am Vortag völlig ausgereicht hatte.

Die DE 60 2004 010 203 T2 beschreibt ein Verfahren zur Berechnung der Restspeicherenergie einer Sekundärzelle. Über einen ziemlich komplexen Berechnungsalgorithmus kann ein Zeitpunkt der vollständigen Entladung ermittelt werden. Dabei wird von einer aktuell vorliegenden Temperatur ausgegangen. Dieses Verfahren funktioniert nicht, wenn sich die Temperatur zwischenzeitlich ändert. Es kann also auch hier vorkommen, dass die Batteriekapazität bereits nicht mehr ausreichen kann, obwohl der ermittelte Entladezeitpunkt noch nicht erreicht ist.

Die DE 102 09 037 A1 beschreibt ein Verfahren, bei dem zum Überwachen der Spannung einer netzunabhängigen Energieversorgung nach einem Ereignis, das die Energieversorgung belastet, und/oder nach einem vorgebbaren Zeitintervall die Spannung gemessen wird. Dabei werden gemessene Spannungswerte wenigstens zweier Ereignisse gespeichert und daraus ein Mittelwert gebildet, der mit einem Schwellenwert verglichen wird. Erst bei Unterschreitung des Schwellenwerts durch den Mittelwert wird ein Alarmsignal erzeugt. Die Mittelwertbildung kann beispielsweise alle 24 Stunden erfolgen. Dies hat den Vorteil, dass der Temperaturverlauf eines ganzen Tages den Mittelwert beeinflusst.

Aufgabe der Erfindung ist es, die Nachteile des Standes zumindest zu verringern.

Diese Aufgabe wird durch den Gegenstand des Anspruchs 1 gelöst. Vorteilhafte Weiterbildungen der Erfindung sind in den Unteransprüchen angegeben.

Eine erfindungsgemäße Flügelanlage weist einen bewegbaren Flügel mit einer Schließvorrichtung auf, die ein Flügelschloss umfasst. Das Flügelschloss ist mit einem Profilzylinder mit Schließbart versehen und verfügt über einen Drehknauf. Der Drehknauf ist zum Schließbart frei rotierbar angeordnet. Zudem kann er derart aktiviert werden, dass er für die Zeit der Aktivierung den im Profilzylinder angeordneten Entriegelungsmotor mit Energie versorgt, sodass dieser den mit ihm rotationswirkverbundenen Schließbart in Entriegelungsstellung dreht. D. h. ein Drehen des Motors führt zu einem Mitdrehen des Schließbarts. Ferner ist im Drehknauf eine autarke Energieversorgungseinrichtung in Form einer Batterie oder eines Akkumulators integriert. Der Drehknauf weist ferner eine Energieüberwachung auf oder ist mit dieser gekoppelt.

Eine Aktivierung des Drehknaufs bei unterschiedlichen Temperaturen belastet die Energieversorgungseinrichtung unterschiedlich und kann daher zu einem unterschiedlichen Entladen der Energieversorgungseinrichtung pro Aktivierung führen. Zudem sinkt die von der Energieversorgungseinrichtung ausgehende Spannung mit sinkenden Umgebungstemperaturen. Bei einer Betriebsspannung von beispielsweise 3 V kann die Energieversorgungseinrichtung bei 10° C eine Spannung von 4 V liefern, wobei sie bei 0° C eine Spannung von beispielsweise 2,7 V liefert, sodass der Drehknauf nicht mehr sicher aktiviert werden kann. Fällt jetzt über Nacht die Umgebungstemperatur über Nacht nun auf die besagten 0 °C, kann die Kapazität der Energieversorgungseinrichtung also nicht mehr ausreichen, obwohl am Tage noch ausreichend Kapazität vorhanden war. Daher ist die Energieüberwachung erfindungsgemäß eingerichtet, eine aktuelle Umgebungstemperatur in Bezug auf die Energieversorgungseinheit sowie eine durch die Energieversorgungseinheit aktuell gelieferte Spannung und/oder Stromstärke zu ermitteln bzw. zu messen. Basierend darauf ermittelt die Energieüberwachung eine aktuelle, maximale erwartbare Restkapazität der Energieversorgungseinheit aus in einer Datenbank hinterlegten Referenzdaten für den jeweiligen Typ von Energieversorgungseinrichtung. Zudem ermittelt die Energieüberwachung für die ermittelte, maximale erwartbare Restkapazität eine zu erwartende minimale Umgebungstemperatur. D. h. wurde für die Restkapazität im September eine Restkapazität von zwei Monaten ermittelt, beinhaltet die Restkapazität beispielsweise den November, in dem Temperaturen unter 0° C möglich sind. Dementsprechend werden diese Temperaturen mit einbezogen. Wenn diese minimale Umgebungstemperatur niedriger ist als die aktuell vorliegende Umgebungstemperatur, ist die Restkapazität mit einiger Wahrscheinlichkeit geringer als die ermittelte, maximale erwartbare Restkapazität. Daher wird in dem Fall auf Basis dieser ermittelten, zu erwartenden minimalen Umgebungstemperatur nun in Verbindung mit der ermittelten aktuellen Spannung und/oder Stromstärke eine wahrscheinliche Restkapazität der Energieversorgungseinheit ermittelt. Schließlich signalisiert die Energieüberwachung beispielsweise einer gekoppelten Gebäudezentrale, wenn die ermittelte, wahrscheinliche Restkapazität eine vorbestimmte, für den Betrieb erforderliche minimale Restkapazität unterschreitet. D. h. es wird nicht die aktuell vorliegende Temperatur zugrunde gelegt sondern die während der künftigen, maximalen erwartbaren Restkapazität zu erwartende niedrigste Temperatur, wodurch mit wesentlich höherer Sicherheit davon ausgegangen werden kann, dass die Energieversorgungseinrichtung auch die wahrscheinliche Restkapazität bzw. daraus resultierende Restlebensdauer über reibungsfrei funktioniert. Zudem kann dadurch der Einfluss des Ruhebetriebs des Drehknaufs zwischen den Aktivierungen besser berücksichtigt werden.

Vorzugsweise sind die Restkapazitäten jeweils durch eine Anzahl an Aktivierungen des Drehknaufs abgebildet. D. h. die Restkapazität ist eigentlich keine Zeitangabe sondern eine Angabe, wie oft der Drehknauf mit dieser Energieversorgungseinrichtung noch sicher aktiviert werden kann. Dies hat den Vorteil, dass die Energieversorgungseinrichtung je nach Aktivierungsfrequenz länger oder kürzer funktioniert, dies aber immer ermittelt werden kann. Eine resultierende Restlebensdauer der Energieversorgungseinrichtung lässt sich beispielsweise mittels Multiplizierens der Restkapazität mit der durchschnittlichen Pause zwischen unmittelbar aufeinander folgenden Aktivierungen vorzugsweise plus einer durchschnittlichen Dauer der Aktivierung ermittelt werden.

Die aktuelle Umgebungstemperatur wird vorzugsweise über einen sich thermisch verändernden elektrischen Widerstand ermittelt, was eine sehr einfache Methode darstellt.

Alternativ oder zusätzlich wird zur Ermittlung der zu erwartenden minimalen Umgebungstemperatur vorzugsweise ein niedrigster Umgebungstemperatur-Wert innerhalb eines vorbestimmten, dem Zeitpunkt des Ermittelns von Spannung und/oder Stromstärke unmittelbar vorausgegangenen Zeitraums mit einbezogen. Dies hat den Vorteil, beispielsweise bei kalten Sommermonaten dies in die Ermittlung der minimalen Umgebungstemperatur einfließen zu lassen.

Zusätzlich oder alternativ können auch Wettervorhersagedaten in Bezug auf die ermittelte maximale erwartbare Restkapazität bzw. Restlebensdauer der Energieversorgungseinrichtung, sofern dies möglich ist, oder hinsichtlich des Zeitraums der Wettervorhersage zugrunde gelegt werden. Dies hat den Vorteil, künftig zu erwartende Temperaturen mit einzubeziehen, insbesondere, wenn diese vom Durchschnitt abweichen. Bei den Wettervorhersagedaten wird entweder die ermittelte maximale erwartbare Restlebensdauer oder der Zeitraum der Wettervorhersage zugrunde gelegt, je nachdem welche Zeitspanne geringer ist.

Weitere Merkmale und Vorteile der Erfindung ergeben sich aus der nachfolgenden Beschreibung bevorzugter Ausführungsformen. Es zeigen:
- Figur 1: ein Schloss gemäß einer Ausführungsform der Erfindung,
- Figur 2: ein Verfahren zum Ermitteln der Restkapazität der Energie-versorgungseinrichtung von Figur 1 gemäß einer Ausfüh-rungsform der Erfindung.

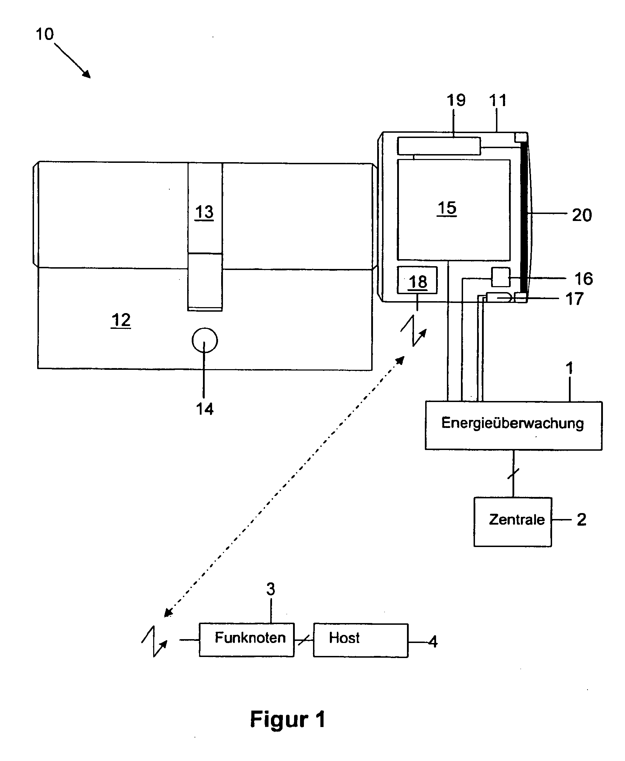

Figur 1 zeigt ein Schloss 10, das in eine Flügelanlage, also einen Flügel, eingesetzt ist. Es umfasst einen Profilzylinder 12 mit Schließbart 13 und Stulploch 14. Vorzugsweise einerends ist auf den Profilzylinder 12 ein Drehknauf 11 aufgesetzt.

Der Drehknauf 11 ist so gestaltet, dass er frei rotierbar zum Schließbart 13 angeordnet ist. Im Drehknauf 11 ist eine autarke Energieversorgungseinrichtung 15 in Form einer Batterie oder eines Akkumulators eingesetzt. Der Drehknauf 11 weist ferner eine Steuerschaltung auf, die bei Aktivierung einen gekoppelten, nicht dargestellten Motor im Profilzylinder 12 derart bestromt, dass dieser den mit ihm rotationswirkverbundenen Schließbart 13 in Entriegelungsrichtung des angeschlossenen, ebenfalls nicht weiter dargestellten Flügelschlosses dreht. Der Drehknauf 11 umfasst zum Aktivieren des Drehknaufs 11 einen Näherungssensor hier in Form eines Lesers 19 mit gekoppelter Leseantenne 20. Der Leser 19 ist eingerichtet, Daten beispielsweise von einer Transponder-Codekarte zu lesen und deren Prüfung auf Berechtigung zum Aktivieren des Drehknaufs 11 auszulösen oder selbst durchzuführen. Der Leser 19 ist mit der Antenne 20 und der Energieversorgungseinrichtung 15 gekoppelt, um die Daten der Codekarte vorteilhafterweise berührungsfrei auslesen zu können.

An einer dem Profilzylinder 12 abgewandten Seite des Drehknaufs 11 ist vorzugsweise eine Anzeige 17 beispielhaft in Form eines Leuchtrings mit dahinter angeordneter LED angeordnet.

Ferner ist in den Drehknauf 11 eine Kommunikationsschnittstelle hier in Form eines Funkmoduls 18 integriert, über die beispielsweise der Leser 19 Kontakt mit einer entfernten Kommunikationsschnittstelle hier in Form eines als Funkknoten ausgebildeten Funkmoduls 3 und darüber mit einem Host-System hier in Form eines Servers 4 aufnehmen kann. Vorzugsweise ist am oder im Drehknauf 11 ein Temperatursensor 16 beispielsweise in Form eines Thermistors so angeordnet, dass mithilfe des Sensors 16 eine aktuelle Umgebungstemperatur ϑₐₖₜ vorzugsweise in Bezug auf den gesamten Drehknauf 11 ermittelt werden kann.

Schließlich ist hier mit dem Drehknauf 11 eine Energieüberwachung 1 mit Prozessor gekoppelt, die zudem exemplarisch mit einer Gebäudezentrale 2 busgekoppelt ist.

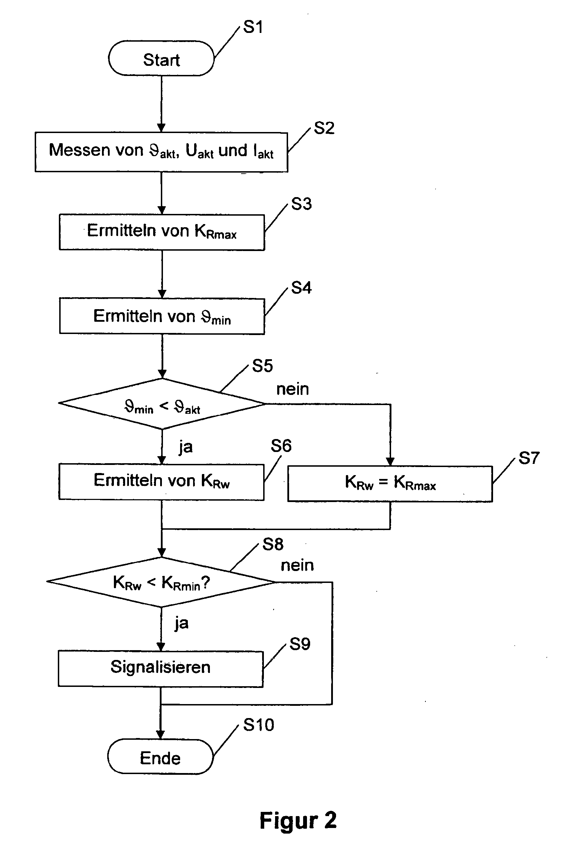

Um eine wahrscheinliche Restkapazität K_{Rw} der Energieversorgungseinrichtung 15 ermitteln zu können, ist ein Verfahren gemäß Figur 2 vorgesehen, das vorzugsweise periodisch wiederholt wird.

Das Verfahren basiert auf der Grundlage vorab ermittelter Entladekurven für den jeweiligen Typ von Energieversorgungseinrichtung 15 bei verschiedenen Umgebungstemperaturen. Bekanntermaßen verringert sich die Leistung der Energieversorgungseinrichtung mit sinkender Temperatur. Die Kurven sind vorzugsweise als Tabellen vorteilhafterweise im Host-System abgelegt, können aber auch im Drehknauf 11 abgelegt sein.

Nach dem Start in Schritt S1 wird in einem Schritt S2 mittels des Sensors 16 eine aktuelle Umgebungstemperatur ϑₐₖₜ bezüglich des Drehknaufs 11 ermittelt bzw. gemessen. Zugleich werden über eine hier nicht weiter dargestellte Messschaltung vorzugsweise sowohl eine aktuelle Ausgangsspannung Uₐₖₜ als auch eine Stromstärke Iₐₖₜ der Energieversorgungseinrichtung 15 ermittelt bzw. gemessen. Da aufgrund des begrenzten Speicherplatzes nicht für jede Umgebungstemperatur Datensätze abgelegt werden können, wird vorzugsweise eine Interpolation zwischen zwei Entladekurven durchgeführt, deren zugeordnete Temperaturen die aktuell gemessene Umgebungstemperatur ϑₐₖₜ bezüglich des Drehknaufs 11 unmittelbar einfassen, wenn die gemessene Umgebungstemperatur ϑₐₖₜ keiner der abgelegten Entladekurven-Temperaturen entspricht.

Im System ist für jede Entladungskurve aufgrund gespeicherter, minimaler Spannungs- und/oder Stromstärkewerte bekannt, ab wann die Funktionssicherheit des Drehknaufs 11 nicht mehr gewährleistet werden kann.

Darauf basierend wird in einem Schritt S3 ermittelt, welche maximale erwartbare Restkapazität K_{Rmax} die Energieversorgungseinrichtung 15 bei der gemessenen Temperatur ϑₐₖₜ noch hat. Da zudem bekannt ist, in welchen Zeitabständen durchschnittlich eine Aktivierung des Drehknaufs 11 zu erwarten ist, kann auf die wahrscheinliche Zeitdauer geschlossen werden, innerhalb der der Drehknauf 11 bei konstanter Umgebungstemperatur weiter funktionieren würde.

Nun treten aber Temperaturschwankungen beispielsweise zwischen Tag und Nacht auf. D. h. niedrige Nachttemperaturen können zu einer verringeraten Restkapazität und damit zu einer geringeren Restlebensdauer der Energieversorgungseinrichtung 15 führen. Um dies in den Griff zu bekommen, wird im Rahmen des Verfahrens in einem nachfolgenden Schritt S4 ermittelt, welche niedrigste Umgebungstemperatur ϑₘᵢₙ für die wahrscheinliche Zeitdauer zu erwarten ist. Dies kann mittels einer Datenbank erfolgen, die beispielsweise für jeden Tag des Jahres die zu erwartenden minimalen Umgebungstemperaturen enthält. Über eine Minimumbetrachtung über den wahrscheinlichen Zeitraum hinweg kann so die niedrigste Umgebungstemperatur ϑₘᵢₙ ermittelt werden.

Nun wird in Schritt S5 geprüft, ob die minimale Umgebungstemperatur ϑₘᵢₙ kleiner als die gemessene Umgebungstemperatur ϑₐₖₜ ist oder nicht. Ist dies der Fall (ja-Zweig nach Schritt S5), wird die Restkapazität nunmehr als wahrscheinliche Restkapazität K_{Rw} ermittelt, nunmehr basierend auf Uₐₖₜ und Iₐₖₜ sowie ϑₘᵢₙ und in der Art wie für ϑₐₖₜ. Andernfalls (nein-Zweig nach Schritt S6) entspricht ϑₐₖₜ bereits der minimalen Umgebungstemperatur, und die maximale erwartbare Restkapazität K_{Rmax} wird dementsprechend nur noch als wahrscheinliche Restkapazität K_{Rw} gesetzt.

In beiden Fällen wird daraufhin in einem nachfolgenden Schritt S8 geprüft, ob die wahrscheinliche Restkapazität K_{Rw} eine vorgegebene minimale Restkapazität K_{Rmin} unterschreitet oder nicht. Ist dies der Fall (ja-Zweig nach Schritt S8), wird dies beispielsweise über die Anzeige 17 signalisiert. Alternativ oder zusätzlich wird die Zentrale 2 informiert. Danach ist das Verfahren in einem Schritt S10 beendet. Andernfalls (nein-Zweig nach Schritt S8) ist das Verfahren sofort beendet.

Die Restkapazitäten K_{Rw}, K_{Rmin}, K_{Rmax} sind vorzugsweise Datensätze in Form von n-Tupeln. Sie umfassen vorzugsweise die Anzahl an möglichen Drehknauf-Aktivierungen, die durchschnittliche Pause zwischen zwei Aktivierungen und die durchschnittliche Dauer der jeweiligen Aktivierung. Dauer und Pause können in einem jeweiligen Zeitwert zusammengefasst sein. D. h. die Restkapazitäten K_{RW}, K_{Rmin}, K_{Rmax} werden mittels einer jeweils zugehörigen Anzahl an Aktivierungen abgebildet. Mittels einfachen Multiplizierens von Anzahl und Zeit kann die wahrscheinliche, sicher vorliegende Restlebensdauer der Energieversorgungseinrichtung 15 berechnet werden. Die Anzahl an Aktivierungen hat den Vorteil, auch wenn der Drehknauf 11 seltener oder häufiger als im Durchschnitt aktiviert wird, weiterhin sicher die wahrscheinliche Restkapazität K_{Rw} ermitteln zu können. Zudem kann die Restanzahl an Aktivierungen beispielsweise in der Zentrale 2 angezeigt werden, um Servicepersonal die Möglichkeit zu geben, einen etwaig anstehenden Wechsel der Energieversorgungseinrichtung 15 zu erkennen.

Das Verfahren hat einen zweiten entscheidenden Vorteil. Aufgrund der aktuell ermittelten Spannung Uₐₖₜ bzw. der Stromstärke Iₐₖₜ tritt auch bei einer teilentladenen Energieversorgungseinrichtung 15 kein Problem auf.

Die minimale Umgebungstemperatur ϑₘᵢₙ muss nicht zwangsläufig auf Basis (nur) der Zukunft ermittelt werden.

Zusätzlich oder alternativ wird die minimale Umgebungstemperatur ϑₘᵢₙ innerhalb eines vorbestimmten, unmittelbar vergangenen Zeitraums, beispielsweise der letzten drei Tage, ermittelt. Dies bietet die Möglichkeit, Temperaturen in Betracht zu ziehen, die vom Durchschnitt abweichen. Damit kann die Vorhersagegenauigkeit hinsichtlich der wahrscheinlichen Restkapazität K_{Rw} verbessert werden.

Wiederum zusätzlich oder alternativ können für die Zukunft auch vorhandene Wettervorhersagedaten genutzt werden. D. h. für die ermittelte maximale erwartbare Restlebensdauer bzw. -kapazität K_{Rmax} oder die Dauer der Wettervorhersage, beispielsweise für die nächsten drei Tage, je nachdem welche Dauer kürzer ist, wird die minimal vorhergesagte Vorhersage-Umgebungstemperatur anstelle anderer, beispielsweise durchschnittlicher Umgebungstemperaturen für diese Dauer genutzt. Auch dadurch lässt sich die Vorhersagegenauigkeit hinsichtlich der wahrscheinlichen Restkapazität K_{Rw} besser an die jeweils vorliegenden Wetterverhältnisse anpassen.

Die Erfindung ist nicht auf die vorbeschriebenen Ausführungen beschränkt.

Die Energieüberwachung 1 kann zumindest teilweise Teil des Drehknaufs 11 sein. Die Zentrale 2 kann entfallen. Die Kopplungen können jeglicher Art sein.

Das Schloss 10 bzw. der Drehknauf 11 kann über einen internen, vorzugsweise nichtflüchtigen Speicher verfügen, in dem Daten berechtigter Codekarten und dazugehörig von berechtigten Personen abgelegt sind. Er beinhaltet somit eine Datenbank. Die Datenbank wird vorzugsweise beim Lesen und Auswerten der Daten der jeweiligen Codekarte genutzt. In dem Fall nimmt der Drehknauf 11 bzw. eine darin aufgenommene Steuerung regelmäßig mit dem Host-System Kontakt auf, um aktualisierte Daten für die Datenbank herunterzuladen. Dies hat den Vorteil, dass dabei überprüft werden kann, ob der Drehknauf 11 funktionstüchtig ist.

Alternativ triggert das Host-System die Steuerung an, aktualisierte Daten zu empfangen. Dies vermindert den Kommunikationsaufwand und unter Umständen auch den Energieverbrauch des Drehknaufs 11.

Zudem kann es anstelle einer einzigen minimalen Restkapazität K_{Rmin} mehrere derartige Restkapazitäten geben, beispielsweise 500, 200, 100, 50, 20, 5 und 1 Aktivierung. Dies ermöglicht, die Anzeige 17 unterschiedlich anzusteuern. Ist K_{RW} > 500, kann der Drehknauf 11 also sicher über 500 Mal aktiviert werden, bleibt die Anzeige 17 dunkel. Gilt K_{Rw} > 0 und K_{Rw} < 500, blinkt die Anzeige 17 beispielhaft rot, und zwar immer schneller, je kleiner die jeweilige minimale Restkapazität ist, die unterschritten wird. Ist keine Aktivierung mehr möglich (K_{Rw} < 1), leuchtet die Anzeige 17 exemplarisch dauerhaft rot. D. h. es lassen sich sozusagen Vorwarnungen hinsichtlich einer sich verringernden Restkapazität der Energieversorgungseinrichtung 15 realisieren.

Als Spannung bzw. Stromstärke werden die-Leerlauf, und/oder Lastspannung bzw. die Stromaufnahme pro Aktivierungs-Zyklus gemessen.

Ferner kann die Kapazitätsentnahme pro Zyklus aus der Energieversorgungseinrichtung 15 berücksichtigt werden, was eine genauere Vorhersage der wahrscheinlichen Restkapazität K_{Rw} ermöglicht.

Mit der Ereindung ist somit eine sehr sichere Vorhersage möglich, wie lang die Energieversorgungseinrichtung 15 noch mit Sicherheit funktioniert.

### Bezugszeichenliste

- 1: Energieüberwachung
- 2: Zentrale
- 3: Funkmodul
- 4: Server

- 10: Schloss
- 11: Drehknauf
- 12: Profilzylinder
- 13: Schließbart
- 14: Stulploch
- 15: Energieversorgungseinrichtung
- 16: Temperatursensor
- 17: Anzeige
- 18: Funkmodul
- 19: Leser
- 20: Antenne

- K_{Rmax}: maximale erwartbare Restkapazität
- K_{Rw}: wahrscheinliche Restkapazität
- K_{Rmin}: minimale Restkapazität
- Uₐₖₜ: aktuell anliegende Spannung
- Iₐₖₜ: aktuell anliegende Stromstärke
- ϑₐₖₜ: aktuelle Umgebungstemperatur
- ϑₘᵢₙ: minimale Umgebungstemperatur

- Si; i ∈ N: Schritt

## Patentansprüche

1. Flügelanlage, aufweisend
• einen bewegbaren Flügel mit einer Schließvorrichtung, umfassend ein Flügelschloss (10) mit
- einem Profilzylinder (12) mit Schließbart (13) und
- einem Drehknauf (11), der
• zum Schließbart (13) frei rotierbar angeordnet ist,
• derart aktivierbar ist, dass der Drehknauf (11) für die Zeit der Aktivierung einen mit dem Schließbart (13) rotationswirkverbundenen Motor derart mit Energie versorgt, dass dieser den Schließbart (13) in eine vorbestimmte Richtung rotiert,
• eine autarke Energieversorgungseinrichtung (15) aufweist und
• eine Energieüberwachung (1) aufweist oder mit dieser gekoppelt ist,
• wobei die Energieüberwachung (1) eingerichtet ist,
- eine aktuelle Umgebungstemperatur (ϑₐₖₜ) in Bezug auf die Energieversorgungseinrichtung (15) zu ermitteln (S2),
- eine durch die Energieversorgungseinrichtung (15) aktuell gelieferte Spannung (Uₐₖₜ) und/oder Stromstärke (Iₐₖₜ) zu ermitteln (S2),
- eine aktuelle, maximale erwartbare Restkapazität (K_{Rmax}) der Energieversorgungseinrichtung (15) aufgrund der gemessenen und ermittelten Werte aus Referenzdaten zu ermitteln (S3),
- eine zu erwartende minimale Umgebungstemperatur (ϑₘᵢₙ) innerhalb der ermittelten maximalen erwartbaren Restkapazität (K_{Rmax}) zu ermitteln (S4),
- eine wahrscheinliche Restkapazität (K_{Rw}) der Energieversorgungseinrichtung (15) aufgrund der ermittelten aktuellen Spannung (Uₐₖₜ) und/oder Stromstärke (Iₐₖₜ) sowie der ermittelten, zu erwartenden minimalen Umgebungstemperatur (ϑₘᵢₙ) zu ermitteln (S5, S6, S7) und
- zu signalisieren (S8, S9), wenn die ermittelte, wahrscheinliche Restkapazität (K_{Rw}) eine vorbestimmte minimale Restkapazität (K_{Rmin}) unterschreitet.

2. Flügelanlage gemäß Anspruch 1, wobei die Restkapazitäten (K_{Rw}, K_{Rmax}, K_{Rmin}) jeweils durch eine Anzahl an Aktivierungen des Drehknaufs (11) abgebildet sind.

3. Flügelanlage gemäß Anspruch 1 oder 2, wobei die aktuelle Umgebungstemperatur (ϑₐₖₜ) über einen sich thermisch verändernden elektrischen Widerstand ermittelt wird.

4. Flügelanlage gemäß einem der vorhergehenden Ansprüche, wobei die zu erwartende minimale Umgebungstemperatur (ϑₘᵢₙ) einem niedrigsten Temperaturwert
• innerhalb eines vorbestimmten, dem Zeitpunkt des Ermittelns der Werte unmittelbar vorausgegangenen Zeitraums und/oder
• aus Wettervorhersagedaten hinsichtlich
- der ermittelten maximalen erwartbaren Restkapazität (K_{Rmax}) oder
- dem Zeitraum der Wettervorhersage entspricht,
• wobei
- der Wettervorhersage-Zeitraum zugrunde gelegt wird, wenn die ermittelte maximale erwartbare Restkapazität (K_{Rmax}) für den Wettervorhersage-Zeitraum ausreicht, und
- andernfalls die ermittelte maximale erwartbare Restkapazität (K_{Rmax}) zugrunde gelegt wird.

## Claims

1. A leaf installation, featuring
• a movable leaf having a closing device, comprising a leaf lock (10) with
- a profile cylinder (12) with a lock bit (13), and
- a rotary knob (11) which
. is disposed to be freely rotatably with regard to the lock bit (13),
. can be activated in such a way that the rotary knob (11), during the time of the activation, supplies energy to a motor which is rotationally and operatively connected to the lock bit (13) in such a way that the lock bit (13) rotates in a predetermined direction,
. features an independent energy supply device (15), and
. features an energy monitoring system (1) or is coupled to the latter,
• wherein the energy monitoring system (1) is adapted
- to determine (S2) an actual ambient temperature (δ_{act}) with regard to the energy supply device (15),
- to determine (S2) a voltage (U_{act}) and/or current intensity (I_{act}) which are/is currently delivered by the energy supply device(15),
- to determine (S3), from reference values, an actual maximum anticipated residual capacity (K_{Rmax}) of the energy supply device (15) on the basis of the measured and determined values,
- to determine (S4) an anticipated minimum ambient temperature (δₘᵢₙ) within the determined maximum anticipated residual capacity (K_{Rmax}),
- to determine (S5, S6, S7) a probable residual capacity (K_{Rw}) of the energy supply device (15) on the basis of the determined actual voltage (U_{act}) and/or current intensity (I_{act}) as well as of the determined minimum ambient temperature (δₘᵢₙ) to be expected, and
- to signal (S8, S9), when the determined probable residual capacity (K_{Rw}) will fall below a predetermined minimum residual capacity (K_{Rmin}).

2. The leaf installation according to claim 1, wherein the residual capacities (K_{Rw}, K_{Rmax}, K_{Rmin}) are respectively represented by means of a number of activations of the rotary knob (11).

3. The leaf installation according to claim 1 or 2, wherein the actual ambient temperature (δ_{act}) is determined by means of a thermally changing electrical resistance.

4. The leaf installation according to any of the preceding claims, wherein the minimum ambient temperature (δₘᵢₙ) to be expected corresponds to a lowest temperature value
• within a predetermined period of time, directly preceding the instant of determining the values, and/or
• derived from weather forecast data with regard to
- the determined maximum residual capacity (K_{Rmax}) to be expected, or
- the duration indicated in the weather forecast,
• wherein
- the period of time of weather forecast is taken as the basic value, if the determined maximum residual capacity (K_{Rmax}) to be expected will be sufficient for the period of time indicated in the weather forecast, and
- otherwise, the determined maximum residual capacity (K_{Rmax}) to be expected will serve as the basic value.

## Revendications

1. Installation de vantaux, présentant
• un vantail mobile avec un dispositif de fermeture, comprenant une serrure de vantail (10) avec
- un cylindre de profilé (12) avec un panneton (13), et
- une manette tournante (11), qui
. est agencée de façon à pouvoir tourner librement par rapport au panneton (13),
. peut être activée de telle façon que la manette tournante (11), pendant la période d'activation, fournit de l'énergie à un moteur qui est connecté en opération et de façon rotative au panneton (13) de sorte que le moteur tourne le panneton (13) dans une direction prédéterminée,
. présente un dispositif d'alimentation en énergie (15) indépendant, et
. présente un dispositif de surveillance d'énergie (1) ou est reliée à celui-ci,
• le dispositif de surveillance d'énergie (1) étant aménagé
- pour déterminer (S2) une température ambiante (δ_{act}) par rapport au dispositif d'alimentation en énergie (15),
- pour déterminer (S2) une tension (U_{act}) et/ou une intensité de courant (I_{act}) actuellement fournie(s) par l'intermédiaire du dispositif d'alimentation en énergie (15),
- pour déterminer (S3), à partir de données de référence, une capacité résiduelle (K_{Rmax}) maximale à anticiper du dispositif d'alimentation en énergie (15) en raison des valeurs mesurées et déterminées,
- pour déterminer (S4), durant la capacité résiduelle (K_{Rmax}) maximale à anticiper déterminée, une température ambiante (δₘᵢₙ) minimale à attendre,
- pour déterminer (S5, S6, S7) une capacité résiduelle (K_{Rw}) probable du dispositif d'alimentation en énergie (15) en raison de la tension (U_{act}) et/ou de l'intensité de courant (I_{act}) actuelles déterminée(s) ainsi que de la température ambiante (δₘᵢₙ) minimale à attendre déterminée, et
- pour signaler (S8, S9) si la capacité résiduelle (K_{Rw}) probable déterminée descend au-dessous d'une capacité résiduelle (K_{Rmin}) prédéterminée minimale.

2. Installation de vantaux selon la revendication 1, dans laquelle les capacités résiduelles (K_{Rw}, K_{Rmax}, K_{Rmin}) sont respectivement représentées par le nombre d'activations de la manette tournante (11).

3. Installation de vantaux selon la revendication 1 ou 2, dans laquelle la température ambiante (δ_{act}) actuelle est déterminée par l'intermédiaire d'une résistance électrique changeant thermiquement.

4. Installation de vantaux selon l'une des revendications précédentes, dans laquelle la température ambiante (δₘᵢₙ) à attendre correspond à une valeur de température la plus basse
• lors d'une période immédiatement précédant le moment de déterminer les valeurs et/ou
• provenant de prévisions météorologiques par rapport à
- la capacité résiduelle (K_{Rmax}) maximale à anticiper déterminée ou
- la durée indiquée par les prévisions météorologiques,
• dans laquelle
- la période des prévisions météorologiques sert de valeur de base, si la capacité résiduelle (K_{Rmax}) maximale à anticiper déterminée est suffisante pour la période des prévisions météorologiques, et
- sinon, la capacité résiduelle (K_{Rmax}) maximale à attendre déterminée sera prise comme valeur de base.
